# EUROPEAN PATENT APPLICATION

(11) **EP 4 614 549 A1**
(43) Date of publication of application: **10.09.2025**
(21) Application number: 24162339.6
(22) Date of filing: 08.03.2024
(51) Int. Cl.: H01L 21/20, H01L 29/20, H01L 29/778

(54) **A SEMICONDUCTOR STRUCTURE AND A METHOD TO PRODUCE A SEMICONDUCTOR STRUCTURE**

(71) Applicant: Epinovatech AB, 223 63 Lund (SE)
(72) Inventor: OLSSON, Martin Andreas, 223 63 Lund (SE)
(74) Representative: Zacco Sweden AB

(57) **Abstract**

A semiconductor structure comprising: a substrate; a first layer arranged on top of the substrate, the first layer comprising at least one AIN layer; a second layer arranged on top of the first layer, the second layer comprising alternate AIN and GaN layers; a third layer arranged on top of the second layer, the third layer comprising at least one vertical conductive GaN structure laterally surrounded by resistive material, the resistive material comprising gallium and a method to producing a semiconductor structure.

## Description

### Technical field

The present invention relates to a semiconductor structure and methods of producing such semiconductor structure.

### Background

Nitride semiconductors have larger bandgaps than silicon. Therefore, transistors made from nitride semiconductors have attracted attention. However, there are still improvements to be made to nitride semiconductor structures.

### Summary of the invention

An object of the present disclosure is to provide a semiconductor structure suitable for making a transistor for high power and/or high voltage and/or high-speed operation. In particular, an object is to provide a semiconductor structure suitable for making a vertical high-electron mobility transistor (HEMT) for high power and/or voltage and/or high-speed operation.

According to a first aspect there is provided a method for producing a semiconductor structure. The method comprising providing a starting structure. The starting structure comprising: a substrate, a first layer on top of the substrate, the first layer comprising AIN, a second layer on top of the first layer, the second layer comprising a first sub-layer and a second sub-layer, wherein the first sub-layer comprises AlₓGa₁₋ₓN, wherein x≥0 and the second sub-layer comprises of Al_{y}Ga_{1-y}N, wherein y≥0, wherein x and y are different such that the first and second sub-layers have different Aluminum-content, a conductive GaN layer on top of the second layer, and a mask on top of the conductive GaN layer.

The method further comprising removing, by etching, unmasked parts of the conductive GaN layer to form a vertical conductive GaN structure from the conductive GaN layer; epitaxially growing resistive material, the resistive material laterally surrounding the vertical conductive GaN structure, such that a third layer is formed, the third layer comprising the vertical conductive GaN structure laterally surrounded by the resistive material, wherein the resistive material comprises gallium nitride; and, removing the mask. The mask may be removed by etching.

A layer or structure being arranged on top of another layer or structure should be understood as the layer or structure being located substantially above the other layer or structure as seen from a side/cross sectional view of the semiconductor structure where the substrate is at the bottom of the view. The layer or structure may be directly in contact with the other layer or structure or otherwise, as long as it is substantially above. This should however not be construed as limiting the two layers or structures from vertically overlapping each other as seen from the same side/cross sectional view. Directional terms such as vertically and laterally should be understood in this same context.

The term arranging is to be understood as forming, by any applicable method, the specified layers and structures. Forming may be understood as e.g. depositing, epitaxially growing, etching, or an integrated lithography-based pattern transfer process to name just a few examples.

The semiconductor structure may be a vertical semiconductor structure.

The semiconductor structure may be used to form a vertical HEMT. For example, the vertical HEMT may be produced by: arranging a first heterojunction structure on top of the third layer, the first heterojunction structure comprising an undoped GaN layer and an AlGaN layer; forming a gate contact above the vertical conductive GaN structure; forming a source/drain contact to the first heterojunction structure, said source/drain contact being laterally offset from the vertical conductive GaN structure; and forming a source/drain contact in the second layer. Thus, the method may be a method for producing a vertical HEMT. When in operation, current may flow from the source/drain contact of the first heterojunction structure laterally along the first heterojunction structure and then vertically along the vertical conductive GaN structure to the source/drain contact in the second layer. Alternatively, the current may flow in the opposite direction. Current flow through the vertical conductive GaN structure may be gated by the gate contact.

It should be understood that the heterojunctions described herein may be configured to form a two-dimensional electron gas (2DEG). Alternatively, the heterojunctions described herein may be configured to form a two-dimensional hole gas (2DHG).

In view of the above, the semiconductor structure may be an intermediate product for forming a vertical HEMT or the vertical HEMT itself.

The inventor has realized that the method provides a way to form the semiconductor structure which is efficient and of low complexity. Further, the resulting semiconductor structure facilitates the production of a vertical HEMT for high power and/or voltage and/or high-speed operation.

For high power and/or voltage and/or high-speed operation, it is important that the resistive material laterally surrounding the vertical conductive GaN structure is of high quality, to resist e.g. high electric fields. It is a realization that by growing the resistive material laterally surrounding the vertical conductive GaN structure epitaxially, a high quality may be achieved. For example, the interface between the vertical conductive GaN structure and the resistive material may be of high quality, e.g. with few interface states. Further, by growing the resistive material epitaxially, the third layer may be crystalline. This may facilitate the formation of heterojunction structures (e.g. the first and/or second heterojunction structure described later). A 2DEG formed at a heterojunction may be very sensitive to crystalline imperfections (e.g. dislocations or surface roughness) propagating from below. For this reason, it is advantageous that layers below, such as the third layer are grown epitaxially. It should be understood that the conductive GaN layer and the second layer may also be epitaxially grown.

For high power and/or voltage and/or high-speed operation, it is important to avoid that a high electrical field arises in certain regions of the vertical HEMT. A uniform and/or low electric field distribution is advantageous. It is a realization that the configuration of the vertical conductive GaN structure is important to achieve uniform and/or low electric field distribution.

The use of a mask and etching unmasked parts of the conductive GaN layer to form the vertical conductive GaN structure is herein advantageous as it facilitates tailoring the shape of the vertical conductive GaN structure such that uniform and/or low electric field distribution is achieved. As an example, by the use of the mask, the vertical conductive GaN structure may be configured to have an elongated shape, thereby advantageously spreading the electric field. As another example, by the use of the mask, the vertical conductive GaN structure may be provided with inclined sidewalls. Thus, the vertical conductive GaN structure may taper (e.g. taper towards the first heterojunction structure (which may be provided at a later stage).

Gallium nitride, GaN, -based semiconductors, i.e. compounds comprising (but not exclusively containing) gallium and nitrogen, provide numerous advantages compared to silicon. Electronic devices based thereon such as semiconductor structures, HEMTs and vertical HEMTs provide a promising candidate for replacing many silicon-based devices.

GaN-based semiconductor structures, such as HEMTs may offer faster switching speeds, increased electron mobility, lower resistances, larger breakdown voltages, etc. Compared to silicon-based transistors, a GaN-based device may offer low on-state resistances, and low switching losses when used as power switching transistors for voltage converter applications.

Further, GaN may exhibit ballistic transport at room temperature, especially if the GaN is in the form of a one-dimensional structure such as e.g. a nanowire. Thus, the vertical conductive GaN structure may be a nanowire, e.g. a tapered nanowire. The ballistic transport may be attributed to GaN having a high optical phonon energy. The optical phonon energy of GaN may be around 4 times higher than the optical phonon energy of other III-V semiconductors. The ballistic transport and/or the high optical phonon energy may lead to a high electron mobility and a lower ON-resistance, Rds(on), which may be advantageous for power chips.

The substrate may comprise silicon. The substrate may comprise silicon with the crystallographic direction (111), ceramic, or silicon carbide 4H-SiC. Silicon substrates are cheap and readily available.

The method may comprise forming of the starting structure.

The first layer may be arranged on top of the substrate by any suitable deposition technique, e.g. sputtering or chemical vapor deposition, CVD, onto the substrate.

The first layer comprises at least one AIN sub-layer. The first layer may be a primer layer. The first layer may comprise nanopillars.

The second layer may be arranged by deposition. The second layer may be formed by deposition techniques such as e.g. MOVPE or CVD.

The second layer comprise at least the first and second sub-layers with different Aluminum-content. However, the second layer may comprise more sub-layers than the first and second sub-layers. The second layer may comprise at least 3 sub-layers, at least 4 sub-layers or at least 5 sub-layers. The different sub-layers of the second layer may be formed from AlGaN having different ratios of Al and Ga content. For example, the second layer may comprise sub-layers alternating between having low and high Aluminum-content. According to one example, the second layer may comprise alternate AIN and GaN sub-layers. The second layer may be a stack of sub-layers. Hence, the second layer may be seen as a superlattice. The first layer and the second layer may together form a buffer layer. The second layer may further comprise strain layer management layers.

The conductive GaN layer may be provided by deposition. The conductive GaN layer may be formed by deposition techniques such as MOVPE or CVD.

The mask may be arranged on top of the conductive GaN layer by any depositing techniques, such as sputtering or chemical vapor deposition, CVD. The mask may be a hard mask, such as a SiO₂ hard mask. Alternatively, other materials may be used, e.g. SiN. The mask may have a thickness of up to 500 nm. The mask may form a microstrip of 1-20 micron in length and 1000 micron in width.

The etching may be made using plasma etching. The plasma etching may be performed with a chlorine plasma with Cl₂ inlet gas flow. The etching may be made by wet etching in KOH.

The second layer may be used as an etch stop layer.

The resistive material is epitaxially grown such that it is laterally surrounding the vertical conductive GaN structure. The third layer comprises the vertical conductive GaN structure laterally surrounded by the resistive material. The resistive material may comprise p-type gallium nitride. In this context, resistive material is to be interpreted as a material configured to form a barrier against current passing through conductive GaN, thereby blocking current pinching off the vertical conductive GaN structure. Thus, the resistive material may alternatively be referred to as barrier material or current blocking material. The resistive material and the vertical conductive GaN structure may comprise a same compound but with opposite doping. Alternatively, the resistive material may have a larger bandgap than the vertical conductive GaN structure.

The resistive material may comprise carbon-doped GaN, magnesium-doped GaN, or iron-doped GaN. A doping concentration may be at least 1*10^¹⁸ cm⁻³, e.g. at least 5*10^¹⁸ cm⁻³. Thus, the doping concentration of p-doped GaN may be 1*10^²⁰ cm⁻³. The doping concentration of carbon-doped GaN may be 5*10^¹⁸ cm⁻³. The doping concentration of iron-doped, such as Fe-doped, GaN may be 10^¹⁹ cm⁻³. The resistive material may comprise a superlattice of p-doped AI(z)Ga(1-z)N and intrinsically doped GaN, wherein said composition z is in the range of 0.1-0.3. The resistive material may have a thickness of less than 500 nm. The resistive material may be a current blocking layer. The term current blocking layer should be understood as a layer that prevents the current to leave the electron transport channel. Having the resistive material act as a current blocking layer may reduce current leakage to/from the at least one vertical conductive GaN structure. In turn, this may lead to reduced transistor losses and higher efficiency operation.

The conductive GaN layer, and hence also the vertical conductive GaN structure, may be n-doped.

The vertical conductive GaN structure may form an electron transport channel. The vertical conductive GaN structure may be elongated in a direction parallel to a plane of the substrate. In other words, the vertical conductive GaN structure may extend from the substrate in a direction parallel to the plane of the substrate. The vertical conductive GaN structure may have a height in a direction orthogonal to the plane of the substrate. The height may be less than 500 nm. The vertical conductive GaN structure may have a length in a first direction parallel to the substrate. The length may be at least 100 microns, e.g. at least 1000 microns. Alternatively, the vertical conductive GaN structure may comprise portions of 10-100 microns. The vertical conductive GaN structure may have a width in a second direction parallel to the substrate. The width may be at least 1 micron, e.g. 5-8 microns. The above dimensions are particularly advantageous for high power and high voltage applications. An elongated vertical conductive GaN structure advantageously spreads the electric field in the finished vertical HEMT device.

The method may further comprise arranging a heterojunction structure on top of the third layer, the heterojunction comprising an undoped GaN layer and an AlGaN layer. The term heterojunction structure should be understood as a singular integral structure which consists of substantially two different structures with a clearly defined interface/transition between the two. The AlGaN may be silicon doped. The AlGaN layer may have a thickness of 10-20 nm. Depositing the heterojunction structure may comprise depositing an AlGaN-layer. Depositing the heterojunction structure may comprise depositing an undoped GaN-layer. The AlGaN-layer and the undoped GaN-layer may together form the heterojunction. The GaN-layer may be arranged to face the third layer. The AlGaN-layer may be arranged on top of the undoped GaN-layer.

The undoped GaN layer and AlGaN layer of the first heterojunction structure may be gallium-polar. A gallium polar layer may be terminated by gallium atoms. The polarity may be controlled by the nitridation temperature during growth of the layer in question or during growth of a previous layer, e.g. during growth of the AIN layer on substrate. When the subsequent GaN layer on the AIN layer is grown with a low nitridation temperature, the GaN layer may become gallium polar. Subsequent layers may then also be gallium polar. On the other hand, when said GaN layer is nitridated at high temperature, and the AIN layer is N-polar, the subsequent GaN layer may become nitrogen polar by nitridation at high temperature. Subsequent layers may then also be nitrogen polar.

The first heterojunction structure may be gallium polar and may comprise a layer stack comprising an undoped GaN layer, an AlGaN layer on top of said undoped GaN layer, and an additional undoped GaN layer on top of said first AlGaN layer. The undoped GaN layer facing the third layer. Such a layer stack may form both a two-dimensional electron gas (2DEG) and a two-dimensional hole gas (2DHG). The 2DEG may form at the interface between the undoped GaN layer and the AlGaN layer of the layer stack. The 2DHG may form at the interface between the AlGaN layer and the additional undoped GaN layer of the layer stack. The use of both a 2DEG and a 2DHG enables large currents.

The first heterojunction structure may on the other hand be nitrogen polar and may comprise a layer stack comprising a AlGaN layer, an undoped GaN layer on top of said AlGaN layer, and an additional AlGaN layer on top of the undoped GaN layer. The AlGaN layer facing the third layer Such a layer stack may form both a two-dimensional electron gas (2DEG) and a two-dimensional hole gas (2DHG). The 2DEG may form at the interface between the AlGaN layer and the undoped GaN layer of the layer stack. The 2DHG may form at the interface between undoped GaN layer and the additional AlGaN layer of the second layer stack. As described above, the use of both a 2DEG and a 2DHG enables large currents.

The method may further comprise arranging a p doped GaN layer on the first heterojunction structure. The use of a p doped GaN layer enables a normally-off transistor.

The act of removing unmasked parts of the conductive GaN layer may be configured to form inclined side walls of the vertical conductive GaN structure. An inclination of the mask may determine the inclination of the vertical conductive GaN structure. For example, if side walls of the mask are inclined, side walls of the vertical conductive GaN structure may become inclined. This may be due to the mask being slowly etched. The inclination may be at least a 5-degree deviation from a normal axis of the substrate.

According to a second aspect there is provided a semiconductor structure. The semiconductor structure comprising: a substrate; a first layer arranged on top of the substrate, the first layer comprising at least one AIN layer; a second layer arranged on top of the first layer, the second layer comprising a first sub-layer and a second sub-layer, wherein the first sub-layer comprises AlₓGa₁₋ₓN, wherein x≥0 and the second sub-layer comprises of Al_{y}Ga_{1-y}N, wherein y≥0, wherein x and y are different such that the first and second sub-layers have different Aluminum-content; a third layer arranged on top of the third layer, the third layer comprising at least one vertical conductive GaN structure laterally surrounded by resistive material, the resistive material comprising gallium.

The semiconductor structure may be produced in accordance with the method according to the first aspect. The features of the semiconductor structure mentioned above in connection with the first aspect, when applicable, apply to this second aspect as well. In order to avoid undue repetition, reference is made to the above.

The semiconductor structure may further comprise a heterojunction structure on top of the third layer, the heterojunction structure comprising an undoped GaN layer and an AlGaN layer, the undoped GaN layer of the heterojunction structure facing the third layer. The undoped GaN layer and the AlGaN layer of the heterojunction structure may be gallium-polar. The heterojunction structure may further comprise an additional undoped GaN layer on top of the AlGaN layer. Details on this embodiment of the heterojunction structure is discussed in more detail above, in order to avoid undue repetition, reference is made to the above.

Alternatively, the semiconductor structure may comprise an alternative heterojunction structure on top of the third layer. This alternative heterojunction comprising an undoped GaN layer and an AlGaN layer, the AlGaN layer facing the third layer. This alternative heterojunction may be nitrogen polar and comprising an additional AlGaN layer on top of the undoped GaN layer.

The semiconductor structure may further comprise a p doped GaN layer arranged on top of the heterojunction structure. The p doped GaN layer may have a thickness of up to 300 nm, e.g. in the range 50-300 nm, e.g. in the range 200-300 nm. The p doped GaN layer may have a doping concentration above 10²⁰ cm⁻³, e.g. above 10²¹ cm⁻³, e.g. above 10²² cm⁻³. Such thicknesses and dopings may be adequate to provide a normally-off transistor.

An In(x')Ga(1-x')N layer of 10-50 nm may be formed underneath the heterojunction structure to provide polarization of the 2DEG.

An In(y')Ga(1-y')N layer of 1-5 nm may be formed between the undoped GaN layer and the AlGaN layer of the heterojunction structure to provide polarization of the 2DEG.

An AIN layer of 1-5 nm may be formed underneath the heterojunction structure to confine electrons to the 2DEG by its band gap and configure the 2DEG by increased polarization by the piezoelectric effect.

The gallium composition of the AI(z')Ga(1-z')N layer of the heterojunction may be z'=1 i.e. AIN to provide piezoelectric polarization.

Both the Aluminum-composition and the AlGaN thickness of the heterojunction may be jointly configured to increase the sheet charge density of the 2DEG.

A side wall of the vertical conductive GaN structure may be inclined. The side wall of the vertical conductive GaN may deviate by at least 5 degrees from a vertical axis.

The substrate may have a thickness less than of 750 micron and the bow is below 10 microns. A thickness less than of 750 microns may be advantageous e.g. from a manufacturing point of view. The substrate may be thinned down, e.g. after formation of source/drain contacts and gate contact. Thinning may be performed by flipping the semiconductor structure upside down and bonding the frontside to a carrier substrate. In this case the substrate on which the first layer is arranged may be called first substrate and the carrier substrate may be called second substrate. The first substrate may have a thickness (e.g. after thinning) of 500 nm to 4 microns. This may facilitate formation of vias through the first substrate. A bow below 10 microns may be advantageous as it may provide a flat semiconductor structure. A semiconductor structure with a bow below 10 microns may facilitate accurate patterning.

The semiconductor structure and methods described herein may be configured for a substantially low dislocation density.

Generally, all terms used in the claims are to be interpreted according to their ordinary meaning in the technical field, unless explicitly defined otherwise herein. All references to "a/an/the [element, device, component, means, step, etc]" are to be interpreted openly as referring to at least one instance of said element, device, component, means, step, etc., unless explicitly stated otherwise. The steps of any method disclosed herein do not have to be performed in the exact order disclosed, unless explicitly stated.

A further scope of applicability of the present invention will become apparent from the detailed description given below. However, it should be understood that the detailed description and specific examples, while indicating preferred embodiments of the invention, are given by way of illustration only, since various changes and modifications within the scope of the invention will become apparent to those skilled in the art from this detailed description.

Hence, it is to be understood that this invention is not limited to the particular component parts of the device described or acts of the methods described as such device and method may vary. It is also to be understood that the terminology used herein is for purpose of describing particular embodiments only, and is not intended to be limiting.

It must be noted that, as used in the specification and the appended claims, the articles "a," "an," "the," and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings does not exclude other elements or steps.

### Brief description of the drawings

The above and other aspects of the present invention will, in the following, be described in more detail with reference to appended figures. The figures should not be considered limiting; instead they should be considered for explaining and understanding purposes.

As illustrated in the figures, the sizes of layers and regions may be exaggerated for illustrative purposes and, thus, are provided to illustrate the general structures. Like reference numerals refer to like elements throughout.
Fig. 1a is a side view of a semiconductor structure according to one embodiment.
Fig. 1b is a side view of a semiconductor structure according to another embodiment.
Fig. 1c is a side view of a semiconductor structure according to yet another embodiment.
Fig. 1d is a side view of a heterojunction structure.
Fig. 1e is a side view of an alternative heterojunction structure.
Fig. 2 is a block diagram of a method for producing a semiconductor structure.
Fig. 3 is a side view of a starting structure for producing any of the semiconductor structures of Figs 1a, 1b, 1c or 5.
Fig. 4 is a block diagram of a method for producing the starting structure.
Fig. 5 is a side view of a semiconductor structure according to a further embodiment.

### Detailed description

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and to fully convey the scope of the invention to the skilled person.

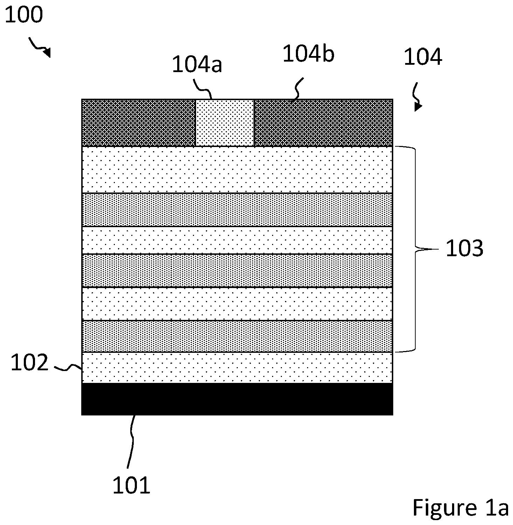

Fig 1a shows a semiconductor structure 100. The semiconductor structure 100 comprises a substrate 101. The substrate 101 may be a silicon, Si, substrate. The substrate 101 may comprise silicon with the crystallographic direction (111), ceramic, or silicon carbide 4H-SiC. The substrate 101 may have a thickness less than of 750 micron and the bow is below 10 microns. The semiconductor structure 100 further comprises a first layer 102. The first layer 102 is arranged on top of the substrate 101. In other words, the first layer 102 are extending in the same plane as the substrate 101. The first layer 102 comprises at least one AIN sub-layer. The first layer 102 may be a primer layer. The first layer 102 may comprise nanopillars.

The semiconductor structure 100 further comprises a second layer 103. The second layer is arranged on top of the first layer 102. The second layer 103 may comprise alternate AIN and GaN layers.

The second layer 103 comprises a plurality of sub-layers. The second layer may comprise at least 2 sub-layers, at least 3 sub-layers, at least 4 sub-layers or at least 5 sub-layers. The different sub-layers of the second layer may be formed from AlGaN having different ratios of Al and Ga content. For example, the second layer may comprise sub-layers alternating between having low and high Aluminum-content. According to one example, the second layer may comprise a first sub-layer comprising AlₓGa₁₋ₓN, wherein x≥0 and a second sub-layer comprising of Al_{y}Ga_{1-y}N, wherein y≥0, wherein x and y are different such that the first and second sub-layers have different Aluminum-content. According to one example, the second layer may comprise alternate AIN and GaN sub-layers. The second layer 103 may be a superlattice.

The first layer 102 and the second layer 103 may together form a buffer layer. The second layer 103 may further comprise strain layer management layers.

The semiconductor structure 100 further comprises a third layer 104. The third layer 104 is arranged on top of the second layer 103. The third layer 104 comprises at least one vertical conductive GaN structure 104a. The at least one vertical conductive GaN structure 104a is laterally surrounded by resistive material 104b. The resistive material 104b comprises gallium. The resistive material 104b may comprise one or more of carbon-doped GaN, p-doped GaN, and iron-doped GaN. A doping concentration may be at least 1*10^¹⁸ cm⁻³, e.g. at least 5*10^¹⁸ cm⁻³. Thus, the doping concentration of p-doped GaN may be 1*10^²⁰ cm⁻³. The doping concentration of carbon-doped GaN may be 5*10^¹⁸ cm⁻³. The doping concentration of iron-doped, such as Fe-doped, GaN may be 10^¹⁹ cm⁻³. The resistive material 104b may have a thickness of less than 500 nm. The resistive material 104b may be a current blocking layer.

The resistive material 104b may be Ga₂O₃. The Ga₂O₃ may be epitaxially regrown selectively with a SiO₂ hard mask 107 masking the vertical conductive GaN structure 104a.

The vertical conductive GaN structure 104a may be n-doped. The vertical conductive GaN structure 104a may be elongated in a direction parallel to a plane of the substrate. In other words, the vertical conductive GaN structure 104a may extend from the substrate in a direction parallel to the plane of the substrate. The vertical conductive GaN structure 104a may form an electron transport channel.

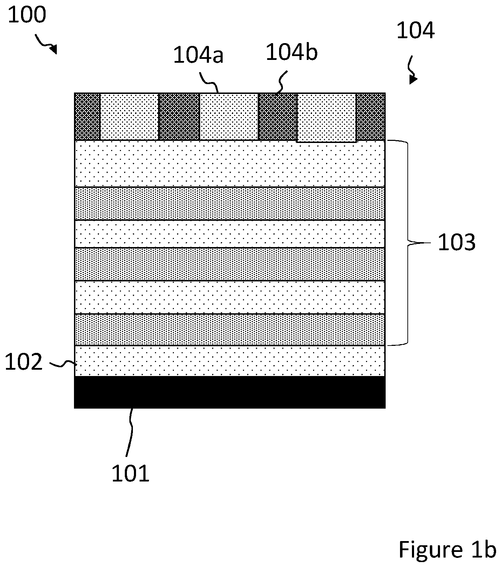

Fig 1b shows a slightly altered version of the semiconductor structure 100, which comprises several vertical conductive GaN structures 104a in the third layer 104. It is readily understood that various number of vertical conductive GaN structures 104a may be present in the semiconductor structure 100 depending on which functionality the semiconductor structure 100 is to provide.

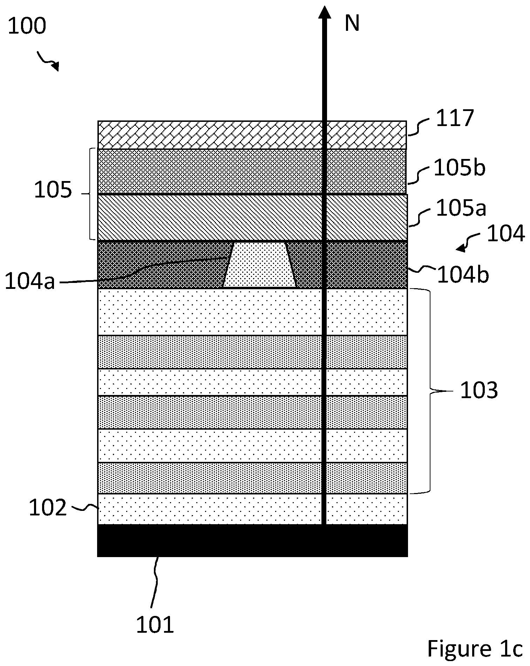

Fig 1c shows the semiconductor structure 100 of Fig 1a with one alteration in the form of inclined vertical surfaces of the vertical conductive GaN structure 104a, and with some additional features in the form of a heterojunction structure 105 arranged on top of the third layer 104 and a p doped GaN layer 117 arranged on top of the heterojunction structure 105.

The heterojunction structure 105 comprises an undoped GaN layer 105a and an AlGaN layer 105b. The undoped GaN layer 105a of the heterojunction structure 105 faces the third layer 104. The undoped GaN layer and AlGaN layer of the first heterojunction structure may be gallium-polar.

The heterojunction structure 105 may have a thickness of 20-30 nm. Thus, the combined thickness of a GaN layer and an AlGaN layer making up the heterojunction structure may be 20-30 nm.

The p doped GaN layer 117 arranged on top of the heterojunction structure 105 may have a thickness of up to 300 nm, e.g. in the range 50-300 nm, e.g. in the range 200-300 nm. The p doped GaN 117 layer may have a doping concentration above 10²⁰ cm⁻³, e.g. above 10²¹ cm⁻³, e.g. above 10²² cm⁻³. Such thicknesses and dopings may be adequate to provide a normally-off transistor.

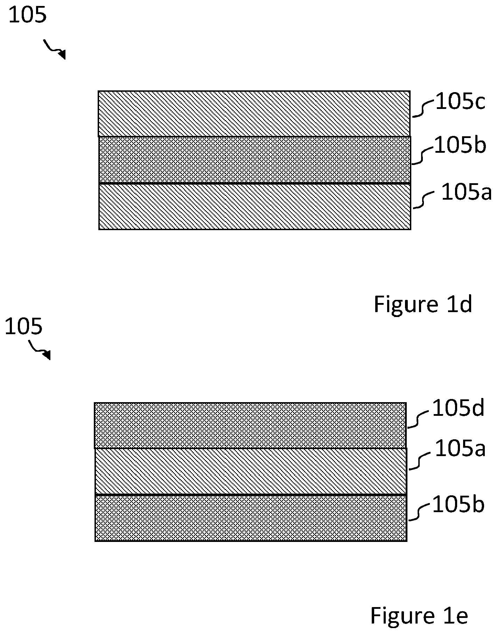

Figs 1d and 1e shows alternative heterojunction structures 105. These different alternative versions of the heterojunction structure 105 are illustrated without the rest of the semiconductor structure 100, this for simplicity, however, it is readily understood that the different heterojunction structures 105 of Figs 1d and 1e can replace the heterojunction structure 105 illustrated in Fig. 1c.

Fig 1d shows a gallium polar heterojunction structure 105. The heterojunction structure 105 comprising a layer stack comprising a first undoped GaN layer 105a, a first AlGaN layer 105b arranged on top of said first undoped GaN layer, and second undoped GaN layer 105c arranged on top of said first AlGaN layer. The first undoped GaN layer 105a is arranged to face the third layer 104 in the semiconductor structure 100.

Fig 1e shows a nitrogen polar heterojunction structure 105. The heterojunction structure 105 comprising a layer stack comprising a first AlGaN layer 105b, a first undoped GaN layer 105a arranged on top of said first AlGaN layer 105b, and second AlGaN layer 105d arranged on top of said first undoped GaN layer 105a. The AlGaN layer 105b is arranged to face the third layer 104 in the semiconductor structure 100.

The p doped GaN layer 117 may be arranged on top of any version of the heterojunction structure 105.

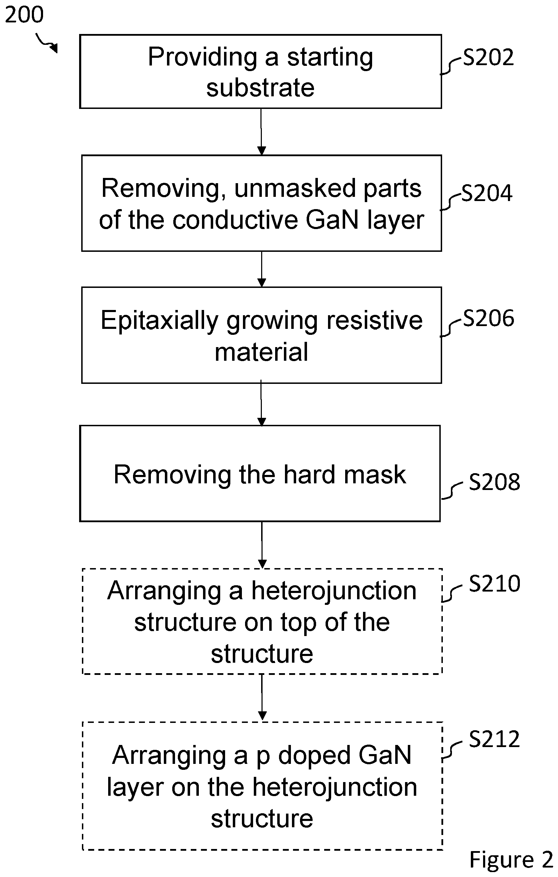

A method 200 of producing a semiconductor structure 100 will now be described with reference to Fig 2. The semiconductor structure 100 is typically the semiconductor structure 100 illustrated and discussed above in connection with Figs 1a to 1e. Fig. 2 is a flow chart illustrating the steps of the method 200. Below, the different steps are described in more detail. Even though illustrated in a specific order, the steps of method 200 may be performed in any suitable order, in parallel, as well as multiple times.

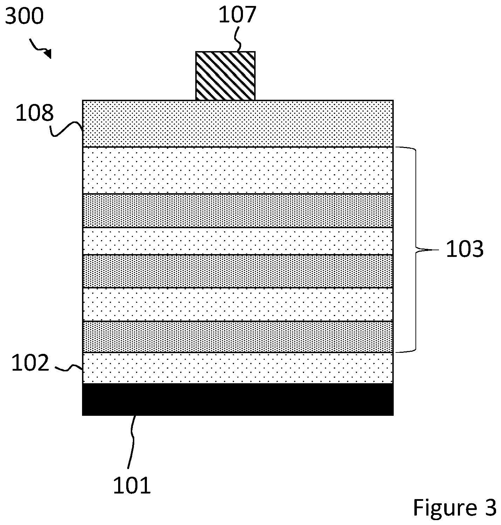

The method 200 comprises providing S202 a starting structure. The starting structure 300 is illustrated in Fig. 3. The starting structure 300 comprises the substrate 101 discussed above. The starting structure 300 further comprises the first layer 102 discussed above. The first layer 102 is arranged on top of the substrate 101. The first layer 102 comprises AIN. The starting structure 300 further comprises the second layer 103 discussed above. The second layer 103 is arranged on top of the first layer 102. The starting structure 300 further comprises a conductive GaN layer 108. The conductive GaN layer 108 is arranged on top of the second layer 103. The conductive GaN layer 108 may be n-doped. The starting structure 300 further comprises a mask 107 arranged on top of the conductive GaN layer 108.

The method 200 further comprises removing S204, by etching, unmasked parts of the conductive GaN layer 108 to form a vertical conductive GaN structure 104a from the conductive GaN layer 108. The etching 206 may be made using plasma etching. The plasma etching may be performed with a chlorine plasma with Cl₂ inlet gas flow. The etching 206 may be made by wet etching in KOH. The act of removing S204 unmasked parts of the conductive GaN layer 108 may be configured to form inclined side walls of the vertical conductive GaN structure 104a. The vertical conductive GaN structure 104a is discussed in more detail above, in order to avoid undue repetition reference is made to this discussion.

The method 200 further comprises epitaxially growing S206 resistive material 104b. The resistive material 104b is grown to laterally surrounding the vertical conductive GaN structure 104a, such that a third layer 104 is formed. The third layer 104 comprises the vertical conductive GaN structure 104a laterally surrounded by the resistive material 104b. The resistive material 104b is discussed in more detail above, in order to avoid undue repetition reference is made to this discussion.

The method 200 further comprises removing S208 the mask. The removing of the mask may be made by plasma etching.

The method 200 may further comprise arranging S210 a heterojunction structure 105 on top of the third layer 104. The heterojunction structrue105 comprising an undoped GaN layer 105a and an AlGaN layer 105b. Different heterojunction structures 105 may be used as discussed above in connection with Figs 1c, d and e. Undoped GaN layers 105a, 105c of the heterojunction structure 105 may be arranged by deposition. For example, the undoped GaN layers 105a, 105c may be formed by deposition techniques such as e.g. MOVPE or CVD. AlGaN layers 105b, 105d of the heterojunction structure 105 may be arranged by deposition. For example, the AlGaN layers 105b, 105d may be formed by deposition techniques such as e.g. MOVPE or CVD.

The method 200 may further comprise arranging S212 a heterojunction structure 105 on top of the third layer 104.

The method 200 may further comprise arranging S212 a p-doped GaN layer 117 on the heterojunction structure 105 by epitaxially growing the p-doped GaN layer by magnesium doping.

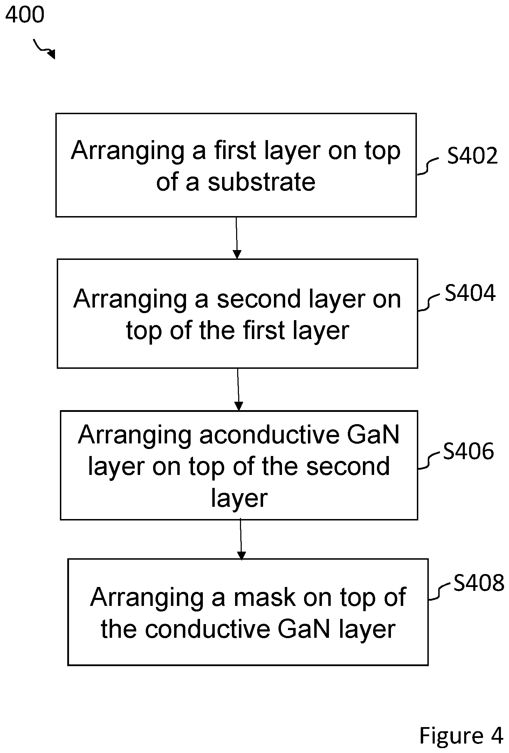

In connection with Fig. 4 a method 400 for producing the starting structure 300 will be discussed. The method 400 may form part of the method 200 of producing the semiconductor structure 100. Fig. 4 is a flow chart illustrating the steps of the method 400. Below, the different steps are described in more detail. Even though illustrated in a specific order, the steps of method 400 may be performed in any suitable order, in parallel, as well as multiple times.

The method 400 comprises arranging S402 the first layer 102 on top of the substrate 101. The first layer 102 may be formed by a suitable deposition technique, e.g. sputtering or chemical vapor deposition, CVD, onto the substrate 101. Sputtered AIN may be advantageous as it may provide a low density of charge traps, e.g. a low density of charge traps at the interface between the AIN-layer 102 and the substrate 101.

The method 400 comprises arranging S404 the second layer 103 on top of the first layer 102. The second layer 103 may be provided by deposition. The second layer 103 may be formed by deposition techniques such as e.g. MOVPE or CVD.

The method 400 comprises arranging S406 the conductive GaN layer 108 on top of the second layer 103. The GaN layer 108 may be provided by deposition. The GaN layer 108 may be formed by deposition techniques such as e.g. MOVPE or CVD.

The method 400 further comprises arranging S408 the mask 107 on top of the conductive GaN layer 108. The mask 107 may be a hard mask, such as a SiO₂ hard mask. The mask 107 may have a thickness of up to 500 nm. The hard mask 107 may form av microstrip of 1-20 micron in length and 1000 micron in width. The mask 107 may be arranged by any depositing techniques, such as sputtering or chemical vapor deposition, CVD.

The method 400 may comprise a step of using lithography-based pattern transfer techniques to define the intended position and geometry of the one or more vertical conductive GaN structures 104a. For instance, positive resist may be spin-coated on the mask 107, exposed by UV light, and then developed. The resist is masking the area(s) where the one or more vertical conductive GaN structures 104a are to be etched.

The person skilled in the art realizes that the present invention by no means is limited to what is explicitly described above. On the contrary, many modifications and variations are possible within the scope of the appended claims.

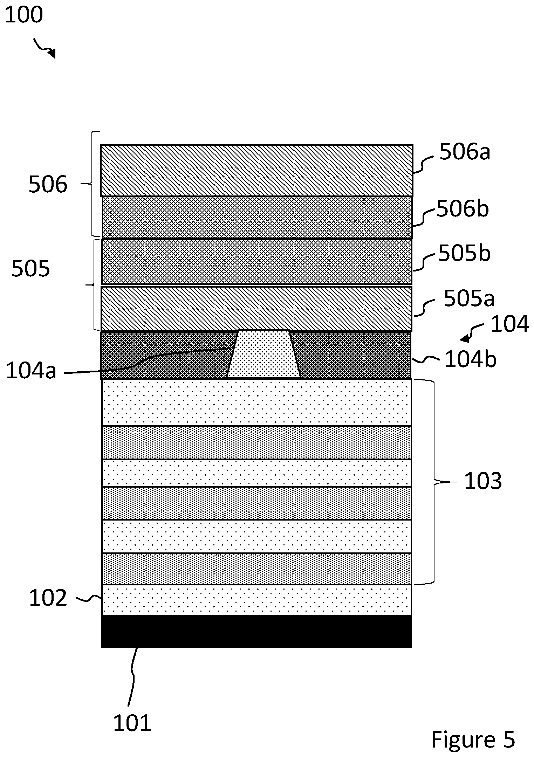

For example, as illustrated in connection with Fig. 5, a first heterojunction structure 505 and a second heterojunction structure 506 may be arranged on the third layer 104. The first heterojunction structure 505 comprises an undoped GaN layer 505a and an AlGaN layer 505b. The undoped GaN layer 505a of the first heterojunction structure 505 faces the third layer 104. The second heterojunction structure 506 is arranged on top of the first heterojunction structure 505. The second heterojunction structure 506 comprises an undoped GaN layer 506a and an AlGaN layer 506b. The AlGaN layer 506b of the second heterojunction structure 506 is facing the AlGaN layer 505b of the first heterojunction structure 505. The first heterojunction structure 505 may have a thickness of 10-30 nm. The second heterojunction structure 506 may have a thickness of 10-30 nm. The undoped GaN layer 505a and AlGaN layer 505b of the first heterojunction structure 505 may be gallium-polar. Alternatively, the undoped GaN layer 506a and the AlGaN layer 506b of the second heterojunction structure 506 may be nitrogen-polar. Nitrogen-polar GaN increases the polarization of the 2DEG compared to gallium-polar GaN. This changes the direction of the polarization field and the band structure with increased polarization. Similar to the Ga-polar 2DEG, the nitrogen-polar 2DEG is a triangular quantum well in the plane in the epitaxial growth direction. Hence, it is advantageous to increase the charge density in the 2DEG for higher electron mobility. This may further be advantageous for high frequency operation and high current scaling with low ON-resistance of GaN HEMT devices.

The undoped GaN layer 506a of the first heterojunction structure 505 may be arranged by deposition on to the third layer 104. The undoped GaN layer 506a may be formed by deposition techniques such as e.g. MOVPE or CVD. The AlGaN layer 505b of the first heterojunction structure 505 may be arranged by deposition on to the undoped GaN layer 506a of the first heterojunction structure 505. The AlGaN layer 505b may be formed by deposition techniques such as e.g. MOVPE or CVD.

The AlGaN layer 506b of the second heterojunction structure 506 may be arranged by deposition on to the AlGaN layer 505b of the first heterojunction structure 505. The AlGaN layer 506b may be formed by deposition techniques such as e.g. MOVPE or CVD. The undoped GaN layer 506a may be provided by deposition on to the AlGaN layer 506b. The undoped GaN layer 506a may be formed by deposition techniques such as e.g. MOVPE or CVD.

Additionally, variations to the disclosed embodiments can be understood and effected by the skilled person in practicing the claimed invention, from a study of the drawings, the disclosure, and the appended claims.

## Claims

1. A semiconductor structure (100) comprising:
a substrate (101);
a first layer (102) arranged on top of the substrate (100), the first layer (102) comprising AIN;
a second layer (103) arranged on top of the first layer (102), the second layer (103) comprising a first sub-layer and a second sub-layer, wherein the first sub-layer comprises AlₓGa₁₋ₓN, wherein x≥0 and the second sub-layer comprises of Al_{y}Ga_{1-y}N, wherein y≥0, wherein x and y are different such that the first and second sub-layers have different Aluminum-content;
a third layer (104) arranged on top of the second layer (103), the third layer (104) comprising at least one vertical conductive GaN structure (104a) laterally surrounded by resistive material (104b), the resistive material (104b) comprising gallium.

2. The semiconductor structure (100) according to claim 1, further comprising:
a heterojunction structure (105) on top of the third layer (104), the heterojunction (105) comprising an undoped GaN layer (105a) and an AlGaN layer (105b), the undoped GaN layer (105a) of the heterojunction (105) facing the third layer (104).

3. The semiconductor structure (100) according to claim 2, wherein the undoped GaN layer (105a) and the AlGaN layer (105b) of the heterojunction structure (105) are gallium-polar.

4. The semiconductor structure (100) according to claim 3, wherein the heterojunction structure (105) further comprises an additional undoped GaN layer (105c) on top of the AlGaN layer (105b).

5. The semiconductor structure (100) according to claim 1, further comprising a heterojunction structure (105) on top of the third layer (104), the heterojunction (105) comprising an undoped GaN layer (105a) and an AlGaN layer (105b), the AlGaN layer (105b) of the heterojunction (105) facing the third layer (104).

6. The semiconductor structure (100) according to claim 5, wherein the heterojunction structure (105) is nitrogen polar and comprises an additional AlGaN layer (105d) on top of the undoped GaN layer (105a).

7. The semiconductor structure (100) according to any one of the claims 2-6, further comprising a p doped GaN layer (117) arranged on top of the heterojunction structure (105).

8. The semiconductor structure (100) according to any one of the claims 1-7, wherein a side wall of the vertical conductive GaN structure (104a) is inclined, wherein the side wall of the vertical conductive GaN (104a) deviates by at least 5 degrees from a normal axis (N) of the substrate (101).

9. The semiconductor structure (100) according to any one of the claims 1-8, wherein the resistive material (104b) comprises one or more of: carbon-doped GaN, magnesium-doped GaN, and iron-doped GaN.

10. The semiconductor structure (100) according to any one of the claims 1-9, wherein the vertical conductive GaN structure (104a) is n-doped.

11. The semiconductor structure (100) according to any one of the claims 1-10, wherein the vertical conductive GaN structure (104a) is elongated in a direction parallel to a plane of the substrate (101).

12. A method for producing a semiconductor structure (100), the method comprising:
providing (201) a starting structure (300) comprising:
a substrate (101),
a first layer (102) on top of the substrate (101), the first layer (102) comprising AIN,
a second layer (103) on top of the first layer (102), the second layer (103) comprising a first sub-layer and a second sub-layer, wherein the first sub-layer comprises AlₓGa₁₋ₓN, wherein x≥0 and the second sub-layer comprises of Al_{y}Ga_{1-y}N, wherein y≥0, wherein x and y are different such that the first and second sub-layers have different Alum inum-content,
a conductive GaN layer (108) on top of the second layer (103), and
a mask (107) on top of the conductive GaN layer (108);
removing (206), by etching, unmasked parts of the conductive GaN layer (108) to form a vertical conductive GaN structure (104a) from the conductive GaN layer (108);
epitaxially growing (207) resistive material (104b), the resistive material (104b) laterally surrounding the vertical conductive GaN structure (104a), such that a third layer (104) is formed, the third layer (104) comprising the vertical conductive GaN structure (104a) laterally surrounded by the resistive material (104b), wherein the resistive material (104b) comprises gallium; and
removing (208) the mask (107).

13. The method according to claim 12, further comprising:
arranging (209) a heterojunction structure (105) on top of the third layer (104), the heterojunction structure (105) comprising an undoped GaN layer (105a) and an AlGaN layer (105b).

14. The method according to claim 13, further comprising:
arranging a p-doped GaN layer (117) on the heterojunction structure (105).

15. The method according to any one of claim 12-14, wherein removing unmasked parts (206) of the conductive GaN layer (108) is configured to form inclined side walls of the vertical conductive GaN structure (104a).
